# EUROPÄISCHE PATENTSCHRIFT

(11) **EP 0 510 427 B1**
(45) Veröffentlichungstag und Bekanntmachung des Hinweises auf die Patenterteilung: **25.09.1996**
(21) Anmeldenummer: 92106042.2
(22) Anmeldetag: 08.04.1992
(51) Int. Cl.: G01R 15/04, G01R 1/20

(54) **Spannungswandler für eine Mittel- oder Hochspannungsanlage**
Voltage transformer for a medium or high voltage installation
Transformateur de tension pour une installation à moyenne ou haute tension

(30) Priorität: 22.04.1991 CH 1197/91
(43) Veröffentlichungstag der Anmeldung: 28.10.1992
(73) Patentinhaber: ASEA BROWN BOVERI AG, CH-5401 Baden (CH)
(72) Erfinder: Haffner, Yves, CH-5400 Baden (CH); Koch, Andreas, CH-5620 Zufikon (CH); Kornfeld, Amos, Dr., CH-5213 Villnachern (CH)

(56) Entgegenhaltungen:
- EP-A- 0 382 274
- FR-A- 2 506 947
- REVIEW OF SCIENTIFIC INSTRUMENTS Bd. 54, Nr. 8, August 1983, NEW YORK US Seiten 1060 - 1062;Z.Y. LEE:'SUBNANOSECOND HIGH-VOLTAGE TWO-STAGE RESISTIVE DIVIDER'

## Beschreibung

### TECHNISCHES GEBIET

Bei der Erfindung wird ausgegangen von einem Spannungswandler nach dem Oberbegriff von Patentanspruch 1.

### STAND DER TECHNIK

Die Erfindung nimmt dabei Bezug auf einen Stand der Technik, wie er sich aus FR-A-2 506 947 ergibt. Ein in dieser Patentveröffentlichung beschriebener Spannungswandler für eine Hochspannungsanlage weist einen rotationssymmetrisch gestalteten und in einer isoliergasgefüllten Metallkapselung angeordneten ohmschen Spannungsteiler als Spannungssensor auf. Der Spannungssensor ist von zwei Widerständen gebildet, von denen ein erster zwischen einem auf Anlagenspannung befindlichen ersten Stromanschluss und einem Abgriffpunkt und ein zweiter zwischen dem Abgriffpunkt und einem auf Masse der Anlage geführten zweiten Stromanschluss geschaltet ist. Der erste Widerstand des ohmschen Spannungsteilers ist in koaxialer Anordnung teilweise von einer sich kegelstumpfförmig erweiternden und auf dem Potential der Anlagenspannung gehaltenen Elektrode umgeben. Diese Elektrode dient der Vergleichmässigung der elektrischen Feldstärke und kompensiert zugleich den Einfluss parasitärer Kapazitäten zwischen dem ersten Widerstand und der Metallkapselung.

Ein weiterer Spannungswandler ist in DE-C2-2930672 beschrieben. Auch dieser Spannungswandler enthält als Spannungssensor einen rotationssymmetrisch gestalteten, ohmschen Spannungsteiler. Der Spannungsteiler ist aus einem Stapel von ohmschen Widerständen aufgebaut, zwischen denen Steuerelemente angebracht sind, die einer kapazitiven Steuerung längs des Widerstandsstapels dienen. Der Spannungsteiler ist in einem metallgekapselten Gehäuseansatz einer gasisolierten, metallgekapselten Hochspannungsschaltanlage angeordnet und mit einem seiner beiden Stromanschlüsse mit Hochspannungspotential und mit dem anderen mit dem Massepotential der Metallkapselung verbunden.

### KURZE DARSTELLUNG DER ERFINDUNG

Der Erfindung, wie sie in Patentanspruch 1 angegeben ist, liegt die Aufgabe zugrunde, einen Spannungswandler der eingangs genannten Art anzugeben, welcher sich auch bei den unterschiedlichsten Betriebsbedingungen der ihn enthaltenden Anlage durch eine hohe Messgenauigkeit auszeichnet.

Der Spannungswandler nach der Erfindung weist auch bei Betriebsbedingungen, bei denen etwa infolge transienter Vorgänge - wie Schalthandlungen oder Blitzstösse - in der Anlage störende elektrische Felder auftreten, eine hohe Messgenauigkeit auf. Zudem weist er einen über viele Grössenordnungen erstreckten Messbereich und eine grosse Linearität in diesem Messbereich auf. Da er ferner vergleichsweise kleine Abmessungen aufweist, kann er problemlos nahezu an beliebigen Stellen in die Anlage eingebaut werden.

Ein bevorzugtes Ausführungsbeispiel der Erfindung und die damit erzielbaren weiteren Vorteile werden nachfolgend anhand von Zeichnungen näher erläutert.

### KURZE BESCHREIBUNG DER ZEICHNUNGEN

In den Zeichnungen ist ein Ausführungsbeispiel der Erfindung vereinfacht dargestellt, und zwar zeigt:
- Fig.1: eine Seitenansicht einer teilweise im Schnitt dargestellten metallgekapselten, gasisolierten Mittelspannungsschaltanlage mit einem Spannungswandler nach der Erfindung, und
- Fig.2: eine Aufsicht auf einen axial geführten Schnitt durch einen Teil des Spannungswandler nach Fig.l.

### WEGE ZUR AUSFÜHRUNG DER ERFINDUNG

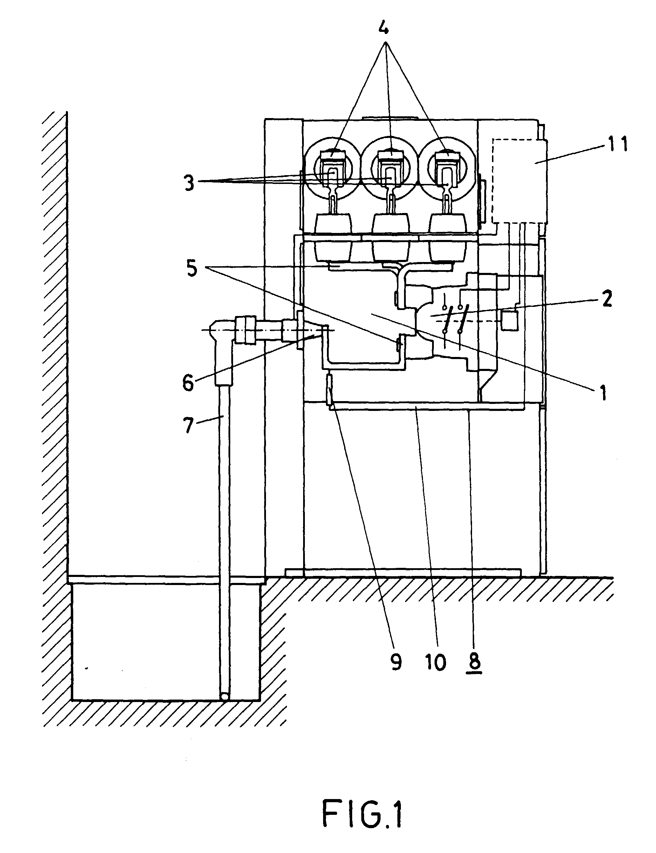

In Fig.1 ist eine metallgekapselte, gasisolierte Mittelspannungsschaltanlage dargestellt,die mit Nennspannungen bis zu 24 kV betrieben werden kann. Diese Anlage weist als Metallkapselung ein geschnitten dargestelltes Gehäuse 1 auf. Das Gehäuse ist mit einem Isoliergas, wie insbesondere SF₆, von bis zu einigen Bar Druck gefüllt. Im Inneren des Gehäuses sind Starkstromkomponenten, wie Leistungsschalter 2, Trennschalter 3 und Sammelschienen 4, angeordnet. Die Starkstromkomponenten sind über Stromleiter 5 phasenweise miteinander elektrisch leitend verbunden. Über Kabeldurchführungen 6 werden die Stromleiter 5 aus dem Gehäuse 1 an Kabel 7 geführt. Die an den Stromleitern 5 anliegenden Spannungen werden phasenweise mittels Spannungswandlern 8 erfasst. Jeder der Spannungswandler 8 weist einen Spannungssensor 9 auf sowie abgeschirmte Messkabel 10 und eine Auswerteelektronik 11, in der die vom Spannungssensor 9 erfassten und über die Messkabel 10 weitergeführten Messignale ausgewertet werden.

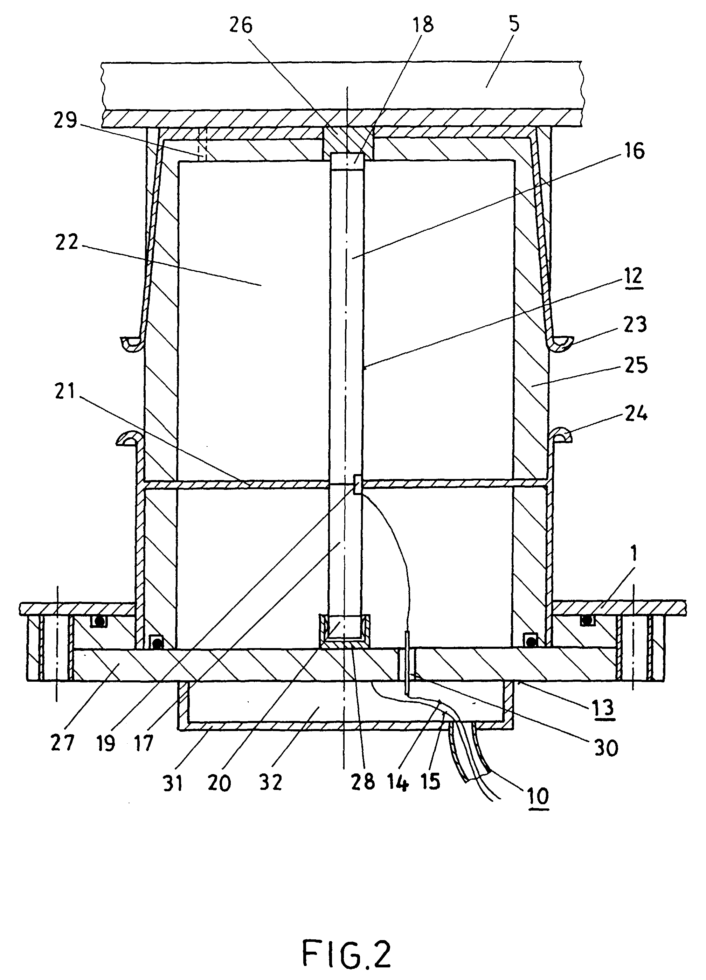

Aus Fig.2 sind Aufbau und Anordnung des den Spannungssensor 9 enthaltenden Teils des Spannungwandlers 8 zu erkennen. Der in dieser Figur gegenüber Fig.1 vergrössert dargestellte Teil des Spannungswandlers 8 enthält einen im wesentlichen rotationssymmetrisch ausgebildeten, ohmschen Spannungsteiler 12, ein den Spannungsteiler 12 umschliessendes und als Abschirmung wirkendes Gehäuse 13 sowie Signalleitungen 14, und 15, die über eines der abgeschirmten Messkabel 10 zur Auswerteelektronik 11 geführt sind.

Der ohmsche Spannungsteiler 12 weist einen einstückig ausgebildeten, zylinderförmigen - vorzugsweise aus Keramik bestehenden - Tragkörper auf. Auf dem Tragkörper sind zwei vorzugsweise in Dickschichttechnologie hergestellte ohmsche Widerstände 16, 17 aufgebracht sind, von denen der Widerstand 16 zwischen einem auf Anlagenspannung befindlichen Stromanschluss 18 und einem Abgriffpunkt 19 und der Widerstand 17 zwischen dem Abgriffpunkt 19 und einem auf Masse der Anlage geführten Stromanschluss 20 geschaltet ist. Hierdurch ist ein besonders einfach und kompakt ausgebildeter ohmscher Spannungsteiler 12 geschaffen, der sich zudem leicht im Gehäuse 13 befestigen und aufgrund seiner regelmässig gestalteten und die Widerstände 16, 17 enthaltenden Oberflächenbereiche hinsichtlich seiner Potentialverteilung vergleichsweise einfach linearisieren lässt. Werte für die beiden Widerstände 16 bzw. 17 sind bei einer Nennspannung von 24 kV typischerweise 200 MΩ bzw. 20 kΩ. Die vom Spannungsteiler 12 abgenommenen Signale weisen dann eine für die Auswerteelektronik 11 geeignete Grösse von 1 bis 2 V auf und die durch den im Spannungsteiler 12 fliessenden Strom bedingte Erwärmung ist dann gegenüber der durch den Betriebsstrom der Anlage bedingten Erwärmung vernachlässigbar.

Der Widerstand 16 ist im Bereich des Abgriffpunktes 19 ringförmig von einer auf Massepotential befindlichen und allseits nahe an den Widerstand 17 herangeführten Abschirmelektrode 21 umgeben. Diese Abschirmelektrode bewirkt, dass bei Betrieb der Anlage den Widerstand 16 gegebenenfalls kurzschliessende Durchschläge vor dem Abgriffpunkt 19 vom Spannungsteiler 12 entfernt werden. Der Messzwecke erfüllende Widerstand 17 und die über die Signalleitungen 14, 15 mit dem Spannungsteiler verbundene Auswerteelektronik werden so vor übermässigen Belastungen geschützt.

Der Spannungsteiler 12 befindet sich in einem vom Gehäuse 13 umschlossenen Raum 22. Koaxial mit dem Spannungsteiler 12 sind zwei mit ihren jeweils als Topfrand ausgebildeten Enden einander gegenüberstehende Elektroden 23, 24 angeordnet. Die als Topf ausgebildete Elektrode 23 befindet sich auf dem Potential eines spannungsführenden Teils der Anlage, wie etwa des Stromleiters 5. Die Elektrode 24 befindet sich hingegen auf dem vorzugsweise geerdeten Massepotential der Anlage. Hierdurch ist der den Spannungsteiler 12 aufnehmende Raum 22 gegenüber dem Einfluss unerwünschter, durch transiente Vorgänge, wie Schalthandlungen oder Blitzstösse, gebildeter elektrischer Störfelder, weitgehend geschützt und werden vom Spannungsteiler 12 daher beim Messen in der Anlage unter Betriebsbedingungen nahezu fehlerfreie Signale abgegeben.

Die jeweils als Topfrand geformten Enden der zwei Elektroden 23, 24 sind vorzugsweise wulstförmig ausgebildet. Die beiden Elektroden können dann besonders nahe zueinander angeordnet sein, wodurch deren Schirmwirkung noch erheblich verbessert wird. Das im vergleichsweise schmalen, ringförmigen Spalt zwischen den Topfrändern herrschende, starke elektrische Feld erschwert das Eindringen unerwünschter elektrischer Störfelder zusätzlich.

Die beiden Elektroden 23 und 24 sind derart gestaltet, dass durch kapazitive Steuerung die Potentialverteilung längs des ohmschen Spannungsteilers 12 beim Auftreten hochfrequenter elektrischer Vorgänge in der Anlage im wesentlichen linear ist. Zu diesem Zweck ist das als Topfwand ausgebildete Teil der auf Spannungspotential gehaltenen Elektrode 23 vom Topfboden zum Topfrand konusförmig erweitert. Eine lokale Überlastung des Widerstandes 16 wird so vermieden.

Beide Elektroden 23, 24 sind zumindest teilweise in einen Topfform aufweisenden Isolierkörper 25 eingebettet. Der Isolierkörper 25 stabilisiert die Lage und die Form der Elektroden 23 und 24. Eine Deformation und eine Verschiebung der Elektroden 23, 24 gegenüber dem Spannungsteiler 12 und damit eine Versteuerung der linearen Potentialverteilung längs des Widerstandes 16 bei Belastung der Anlage beispielsweise mit Stossentladungen entfällt so weitgehend. Zudem ermöglicht der Isolierkörper 25 ein noch näheres Aneinanderführen der beiden Elektroden 23, 24 und damit eine noch bessere Abschirmung des den Spannungsteiler 12 enthaltenden Raumes 22.

Der Isolierkörper 25 enthält ein überwiegend isotropes Isoliermaterial. Hierdurch ist sichergestellt, dass sich der Isolierkörper 25 bei Temperaturänderungen in allen Richtungen gleichmässig dehnen bzw. zusammenziehen kann. Die Geometrie der Elektroden 23, 24 wird daher bei Temperaturveränderungen lediglich linear verändert. Diese Änderung kann durch eine ständige Temperaturüberwachung der Anlage und eine aus dieser Überwachung resultierende ständige Anpassung der Auswerteelektronik 11 leicht kompensiert werden. Eine besonders hohe Messgenauigkeit lässt sich erreichen, wenn das Material des Isolierkörpers 25 eine mit Glaskügelchen gefüllte Vergussmasse, insbesondere auf der Basis eines Epoxidharzes ist.

Der Isolierkörper 25 weist in seinem als Topfboden ausgebildeten Teil eine elektrische Durchführung 26 auf, deren aus dem Topf in die Anlage geführtes Ende mit einem spannungsführenden Teil der Anlage, wie etwa dem Stromleiter 5, und deren ins Innere des Topfes geführtes Ende mit dem auf Anlagenspannung befindlichen Stromanschluss 18 des ohmschen Spannungsteilers 12 elektrisch leitend verbunden ist.

Der Isolierkörper 25 ist unter vollständiger Bildung des Gehäuses 13 mit einem Metalldeckel 27 gasdicht abgeschlossen. Der Metalldeckel 27 ist auf das Massepotential der Anlage geführt und trägt eine ebenfalls auf Massepotential befindliche Metallhülse 28, in welcher der Stromanschluss 20 in Längsrichtungs des Spannungsteilers 12 verschieblich gelagert ist. Der Potentialübergang vom Stromanschluss 20 zur Hülse 28 erfolgt mit Vorteil mittels eines als Mehrkontaktlamelle ausgeführten Gleitkontaktes. Der Spannungsteiler 12 ist so hinsichtlich der durch die Elektroden 23, 24 bestimmten Zylindersymmetrie definiert befestigt und kann sich zu Zwecken des Dehnungsausgleichs bei Temperaturänderungen in axialer Richtung geringfügig verschieben.

Das gasdichte Aufbringen des Deckels 27 ist hierbei von Vorteil, wenn das Gehäuse 13 - wie aus Fig.2 ersichtlich ist - in das mit Isoliergas gefüllte Gehäuse 1 der Anlage eingesetzt ist. Es kann dann nämlich über eine in dem als Topfboden ausgebildeten Teil des Isolierkörpers 25 befindliche Öffnung 29 Isoliergas aus der Anlage in den Raum 22 treten. Dieses Gas verbessert die dielektrischen Bedingungen im Raum 22 und damit die Betriebssicherheit des Spannungswandlers 8 erheblich. Es ist aber auch denkbar, dass die Anlage und damit auch der Spannungsteiler 12 in Luft betrieben werden, wodurch sich ein gasdichtes Verschliessen des Gehäuses 13 erübrigt.

Der Metalldeckel 27 weist eine gasdichte elektrische Durchführung 30 auf zur Ausleitung der mit dem Abgriffpunkt 19 des ohmschen Spannungsteilers 12 galvanisch verbundenen Signalleitung 14 in einen von einem topfförmigen Abschirmkörper 31 begrenzten,dielektrisch abgeschirmten Hohlraum 32. Der Abschirmkörper ist hierbei mit seinem Rand auf dem Metalldeckel 27 befestigt. Im Inneren des vom Abschirmkörper 31 begrenzten Hohlraums 32 ist die Signalleitung 15 elektrisch leitend mit dem Metalldeckel 27 verbunden. Der Abschirmkörper 31 enthält eine nicht bezeichnete Öffnung, durch welche die beiden Signalleitungen 14, 15 aus dem Hohlraum 32 in die mit der Auswerteelektronik 11 des Stromwandlers verbundene Abschirmung des abgeschirmten Messkabels 10 geführt sind. Bei der beschriebenen Ausführungsform werden so beide Signalleitungen 14 und 15 gegenüber störenden elektrischen Feldern weitestgehend geschützt in das abgeschirmte Messkabel 10 eingeführt. In der Auswerteelektronik 11 des Spannungswandlers 8 stehen dann unter gleichen Bedingungen ermittelte Mess- (Signalleiter 14) und Refererenzsignale (Signalleiter 15) zur Verfügung, aus denen die zu ermittelnden Spannungswerte mit grosser Genauigkeit bestimmt werden können.

### BEZUGSZEICHENLISTE

- 1: Gehäuse
- 2: Leistungsschalter
- 3: Trennschalter
- 4: Sammelschienen
- 5: Stromleiter
- 6: Kabeldurchführung
- 7: Kabel
- 8: Spannungswandler
- 9: Spannungssensor
- 10: abgeschirmtes Kabel
- 11: Auswerteelektronik
- 12: Spannungsteiler
- 13: Gehäuse
- 14, 15: Signalleitungen
- 16, 17: Widerstände
- 18: Stromanschluss
- 19: Abgriffpunkt
- 20: Stromanschluss
- 21: Abschirmelektrode
- 22: Raum
- 23, 24: Elektroden
- 25: Isolierkörper
- 26: Durchführung
- 27: Metalldeckel
- 28: Metallhülse
- 29: Öffnung
- 30: Durchführung
- 31: Abschirmkörper
- 32: Hohlraum

## Patentansprüche

1. Spannungswandler (8) für eine Mittel- oder Hochspannungsanlage, enthaltend
- einen rotationssymmetrisch gestalteten und in einem gegenüber elektrischen Feldern weitgehend abgeschirmten Raum (22) angeordneten ohmschen Spannungsteiler (12) als Spannungssensor (9), welcher einen Tragkörper aufweist, auf dem mindestens zwei Widerstände (16, 17) aufgebracht sind, von denen ein erster (16) zwischen einem auf Anlagenspannung befindlichen ersten Stromanschluss (18) und einem Abgriffpunkt (19) und ein zweiter (17) zwischen dem Abgriffpunkt (19) und einem auf Masse der Anlage geführten zweiten Stromanschluss (20) geschaltet ist, und
- in koaxialer Anordnung mit dem Spannungsteiler (12) eine auf dem Potential der Anlagenspannung befindliche, topfförmig ausgebildete erste Elektrode (23),
dadurch gekennzeichnet, dass zur Abschirmung des Raumes (22) in koaxialer Anordnung mit dem Spannungsteiler (12) ausser der ersten (23) eine auf dem Massepotential der Anlage gehaltene zweite Elektrode (24) vorhanden ist mit einem als Topfrand ausgebildeten Ende, welches unter Bildung eines Spaltes einem als Topfrand ausgebildeten Ende der ersten Elektrode (23) gegenübersteht, und dass die erste (23) und die zweite Elektrode (24) zumindest teilweise in einen Topfform aufweisenden Isolierkörper (25) eingebettet sind.

2. Spannungswandler nach Anspruch 1, dadurch gekennzeichnet, dass der erste Widerstand (16) im Bereich des Abgriffpunktes (19) von einer auf Massepotential befindlichen und allseits nahe an den ersten Widerstand (16) herangeführten Lochscheibenförmigen Abschirmelektrode (21) umgeben ist.

3. Spannungswandler nach einem der Ansprüche 1 oder 2, dadurch gekennzeichnet, dass die als Topfränder ausgebildeten Enden der ersten (23) und der zweiten Elektrode (24) wulstförmig ausgebildet sind.

4. Spannungswandler nach Anspruch 3, dadurch gekennzeichnet, dass die erste (23) und zweite Elektrode (24) derart gestaltet sind, dass die Potential verteilung längs des ohmschen Spannungsteilers (12) beim Auftreten hochfrequenter elektrischer Vorgänge in der Anlage im wesentlichen linear ist, wobei der als Topfwand ausgebildete Teil der auf Spannungspotential gehaltenen ersten Elektrode (23) vom Topfboden zum Topfrand konusförmig erweitert ist.

5. Spannungswandler nach einem der Ansprüche 1 bis 4, dadurch gekennzeichnet, dass der Isolierkörper (25) aus überwiegend isotropem Material gebildet ist.

6. Spannungswandler nach Anspruch 5, dadurch gekennzeichnet, dass das Material des Isolierkörpers (25) einen an das Material der ersten (23) und der zweiten Elektroden (24) angepassten Koeffizienten der Wärmeausdehnung aufweist.

7. Spannungswandler nach Anspruch 6, dadurch gekennzeichnet, dass der Isolierkörper (25) von einer mit kugelförmigen Teilchen gefüllten, ausgehärteten Vergussmasse gebildet ist.

8. Spannungswandler nach einem der Ansprüche 1 bis 7, dadurch gekennzeichnet, dass der Isolierkörper (25) in seinem als Topfboden ausgebildeten Teil eine elektrische Durchführung (26) aufweist, deren aus dem Topf in die Anlage geführtes Ende mit dem spannungsführenden Teil (5) der Anlage und deren ins Innere des Topfes geführtes Ende mit dem auf Anlagenspannung befindlichen ersten Stromanschluss (18) des ohmschen Spannungsteilers (12) elektrisch leitend verbunden ist.

9. Spannungswandler nach Anspruch 8, dadurch gekennzeichnet, dass der Isolierkörper (25) in seinem als Topfboden ausgebildeten Teil zusätzlich eine ins Topfinnere geführte Öffnung (29) aufweist.

10. Spannungswandler nach einem der Ansprüche 1 bis 9, dadurch gekennzeichnet, dass der Isolierkörper (25) mit einem den zweiten Stromanschluss (20) des ohmschen Spannungsteilers (12) kontaktierenden Metalldeckel (27) gasdicht abgeschlossen ist.

11. Spannungswandler nach Anspruch 10, dadurch gekennzeichnet, dass der Metalldeckel (27) eine gasdichte elektrische Durchführung (30) aufweist zur Ausleitung einer mit dem Abgriffpunkt (19) des ohmschen Spannungsteilers (12) galvanisch verbundenen ersten Signalleitung (14).

12. Spannungswandler nach Anspruch 11, dadurch gekennzeichnet, dass auf dem Metalldeckel (27) der Rand eines topfförmig ausgebildeten Abschirmkörpers (31) befestigt ist, dass im Inneren des vom Abschirmkörper (31) begrenzten Hohlraums (32) eine zweite Signalleitung (15) elektrisch leitend mit dem Metalldeckel (27) verbunden ist, und dass der Abschirmkörper (31) eine Öffnung aufweist, durch welche die erste (14) und die zweite Signalleitung (15) aus dem Hohlraum (32) in eine mit einer Auswerteelektronik (11) des Spannungswandlers (8) elektrisch leitend verbundene Abschirmung eines abgeschirmten Messkabels (10) geführt sind.

## Claims

1. Voltage transformer (8) for a medium-voltage or high-voltage installation, containing
- as voltage sensor (9) an ohmic voltage divider (12), which is of rotationally symmetrical configuration and is arranged in a space (22) largely screened against electric fields, and which has a supporting body on which there are mounted at least two resistors (16, 17) of which a first (16) is connected between a first power supply connection (18) at installation voltage and a tapping point (19), and a second (17) is connected between the tapping point (19) and a second power supply connection (20), which is led to installation frame, and
- in a coaxial arrangement with the voltage divider (12), a first electrode (23) of pot-shaped construction at the potential of the installation voltage,
characterized in that, for the purpose of screening the space (22), in addition to the first (23) electrode there is present in the coaxial arrangement with the voltage divider (12) a second electrode (24) which is kept at the frame potential of the installation and has an end which is constructed as a pot rim and is situated, forming a gap, opposite an end, constructed as a pot rim, of the first electrode (23), and in that the first electrode (23) and the second electrode (24) are embedded at least partially in an insulating body (25) having the shape of a pot.

2. Voltage transformer according to Claim 1, characterized in that in the region of the tapping point (19) the first resistor (16) is surrounded by a screening electrode (21) which is in the shape of a perforated plate, is at frame potential, and is brought up on all sides close to the first resistor (16).

3. Voltage transformer according to one of Claims 1 or 2, characterized in that the ends, constructed as pot rims, of the first electrode (23) and the second electrode (24) are constructed in the shape of a curl.

4. Voltage transformer according to Claim 3, characterized in that the first electrode (23) and second electrode (24) are configured such that the potential distribution along the ohmic voltage divider (12) is essentially linear in the case of the occurrence of highfrequency electric processes in the installation, the part, constructed as a pot wall, of the first electrode (23) kept at the voltage potential being conically expanded from the pot floor to the pot rim.

5. Voltage transformer according to one of Claims 1 to 4, characterized in that the insulating body (25) is formed from predominantly isotropic material.

6. Voltage transformer according to Claim 5, characterized in that the material of the insulating body (25) has a coefficient of thermal expansion which is matched to the material of the first electrode (23) and of the second electrode (24).

7. Voltage transformer according to Claim 6, characterized in that the insulating body (25) is formed by a cured potting compound filled with spherical particles.

8. Voltage transformer according to one of Claims 1 to 7, characterized in that in its part constructed as pot floor the insulating body (25) has an electrical bushing (26) whose end led from the pot into the installation is connected in an electrically conductive fashion to the live part (5) of the installation, and whose end led into the interior of the pot is connected in an electrically conductive fashion to the first power supply connection (18), which is at the installation voltage, of the ohmic divider (12).

9. Voltage transformer according to Claim 8, characterized in that in its part constructed as pot floor the insulating body (25) additionally has an opening (29) led into the pot interior.

10. Voltage transformer according to one of Claims 1 to 9, characterized in that the insulating body (25) is sealed in a gas-tight fashion by a metal cover (27) which contacts the second power supply connection (20) of the ohmic voltage divider (12).

11. Voltage transformer according to Claim 10, characterized in that the metal cover (27) has a gas-tight electrical bushing (30) for the purpose of leading out a first signal line (14), which is electrically connected to the tapping point (19) of the ohmic voltage divider (12).

12. Voltage transformer according to Claim 11, characterized in that the rim of a screening body (31) constructed in the shape of a pot is fastened to the metal cover (27), in that in the interior of the cavity (32) bounded by the screening body (31) a second signal line (15) is connected in an electrically conductive fashion to the metal cover (27), and in that the screening body (31) has an opening through which the first signal line (14) and the second signal line (15) are led from the cavity (32) into a screen of a screened measuring cable (10), which screen is connected in an electrically conductive fashion to an electronic evaluation system (11) of the voltage transformer (8).

## Revendications

1. Transformateur de tension (8) pour une installation à moyenne ou haute tension, comprenant
- un diviseur de tension ohmique (12) à symétrie de révolution et disposé dans une chambre (22) fortement blindée contre les champs électriques, à titre de capteur de tension (9) qui comprend un corps de support, sur lequel sont disposées au moins deux résistances (16, 17), dont une première (16) est montée entre une première borne de courant (18) se trouvant à la tension de l'installation et un point de prise (19) et dont une deuxième (17) est montée entre le point de prise (19) et une deuxième borne de courant (20) mise à la masse de l'installation, et
- dans une disposition coaxiale avec le diviseur de tension (12), une première électrode (23) se trouvant au potentiel de la tension de l'installation et se présentant sous la forme d'un pot,
caractérisé en ce que pour le blindage de la chambre (22), dans une disposition coaxiale avec le diviseur de tension (12), en plus de la première électrode (23), est prévue une deuxième électrode (24) maintenue au potentiel de la masse de l'installation et pourvue d'une extrémité conçue comme un bord de pot, qui fait face à une extrémité conçue comme un bord de pot de la première électrode (23), formant ainsi un intervalle, et en ce que la première (23) et la deuxième (24) électrodes sont noyées au moins en partie dans un corps isolant (25) se présentant sous la forme d'un pot.

2. Transformateur de tension suivant la revendication 1, caractérisé en ce que la première résistance (16) est entourée dans la région du point de prise (19) par une grille de protection (21) en forme de disque perforé, qui se trouve au potentiel de la masse et qui est amenée de tous côtés à proximité de la première résistance (16).

3. Transformateur de tension suivant l'une ou l'autre des revendications 1 et 2, caractérisé en ce que les extrémités, conçues en forme de bords de pot, de la première (23) et de la deuxième (24) électrodes ont la forme de bourrelets.

4. Transformateur de tension suivant la revendication 3, caractérisé en ce que la première (23) et la deuxième (24) électrodes ont des formes telles que la répartition du potentiel le long du diviseur de tension ohmique (12) soit essentiellement linéaire lors de l'apparition de phénomènes électriques haute fréquence dans l'installation, sachant que la partie, conçue en forme de paroi de pot, de la premiére électrode (23) maintenue au potentiel de tension est évasée en cône depuis le fond du pot jusqu'au bord du pot.

5. Transformateur de tension suivant l'une quelconque des revendications 1 à 4, caractérisé en ce que le corps isolant (25) est fait d'une matière principalement isotrope.

6. Transformateur de tension suivant la revendication 5, caractérisé en ce que la matière du corps isolant (25) présente un coefficient de dilatation thermique adapté à la matière de la première (23) et de la deuxième (24) électrodes.

7. Transformateur de tension suivant la revendication 6, caractérisé en ce que le corps isolant (25) est fait d'une matière de remplissage durcie, remplie de particules sphériques.

8. Transformateur de tension suivant l'une quelconque des revendications 1 à 7, caractérisé en ce que le corps isolant (25) présente, dans sa partie conçue en forme de fond de pot, une traversée électrique (26), dont l'extrémité dirigée du pot dans l'installation est connectée électriquement à la partie sous tension (5) de l'installation et dont l'extrémité dirigée à l'intérieur du pot est connectée électriquement à la borne de courant (18), qui se trouve à la tension de l'installation, du diviseur de tension ohmique (12).

9. Transformateur de tension suivant la revendication 8, caractérisé en ce que le corps isolant (25) comporte en outre, dans sa partie conçue en forme de fond de pot, une ouverture (29) s'ouvrant à l'intérieur du pot.

10. Transformateur de tension suivant l'une quelconque des revendications 1 à 9, caractérisé en ce que le corps isolant (25) est fermé de manière étanche aux gaz au moyen d'un couvercle métallique (27) qui établit un contact avec la deuxième borne de courant (20) du diviseur de tension ohmique (12).

11. Transformateur de tension suivant la revendication 10, caractérisé en ce que le couvercle métallique (27) comporte une traversée électrique (30) étanche aux gaz, destinée à la sortie d'une première ligne de transmission de signaux (14) connectée galvaniquement au point de prise (19) du diviseur de tension ohmique (12).

12. Transformateur de tension suivant la revendication 11, caractérisé en ce que sur le couvercle métallique (27) est fixé le bord d'un corps de blindage (31) en forme de pot, en ce qu'à l'intérieur de l'espace vide (32) délimité par le corps de blindage (31) une deuxième ligne de transmission de signaux (15) est connectée électriquement au couvercle métallique (27), et en ce que le corps de blindage (31) comporte une ouverture, par laquelle la première (14) et la deuxième (15) lignes de transmission de signaux sont amenées hors de l'espace vide (32) dans un blindage du câble de mesure blindé (10) connecté électriquement à une boîte électronique d'évaluation (11) du transformateur de tension (8).
